Europäisches Patentamt

European Patent Office

Office européen des brevets

(19)

(11) **EP 1 489 632 A2**

(12) **EUROPEAN PATENT APPLICATION**

(43) Date of publication:
**22.12.2004 Bulletin 2004/52**

(51) Int Cl.⁷: **H01C 13/00**

(21) Application number: **04252788.7**

(22) Date of filing: **13.05.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **16.06.2003 US 462155**

(71) Applicant: **Hewlett-Packard Development
Company, L.P.
Houston, TX 77070 (US)**

(72) Inventors:
• **Sharma, Manish
Mountain View, CA 94043 (US)**
• **Lee, Heon
Pohang-Si Kyungbuk (KR)**

(74) Representative: **Jehan, Robert et al
Williams Powell
Morley House
26-30 Holborn Viaduct
London EC1A 2BP (GB)**

(54) **Adjustable resistor**

(57)     The invention includes an integrated adjustable resistor (200). The integrated adjustable resistor (200) includes a first electrode (212), a second electrode (214), and a phase change medium (210) electrically connected to the first electrode (212) and the second electrode (214). The integrated adjustable resistor (200) further includes an adjustable pulse generator (220) for applying a variable amount of energy to the phase change medium (210). A resistance of the phase change medium (210) is continuously dependent upon the amount of energy applied to the phase change medium (210). A resistance dependent circuit (2301 is electrically connected to the first electrode (212) and the second electrode (214). Operation of the resistance dependent circuit (230) is continuously dependent upon the resistance of the phase change medium (210).

FIGURE 2

**Description**

The present invention relates generally to analogue circuitry, preferably to an adjustable phase change material resistor.

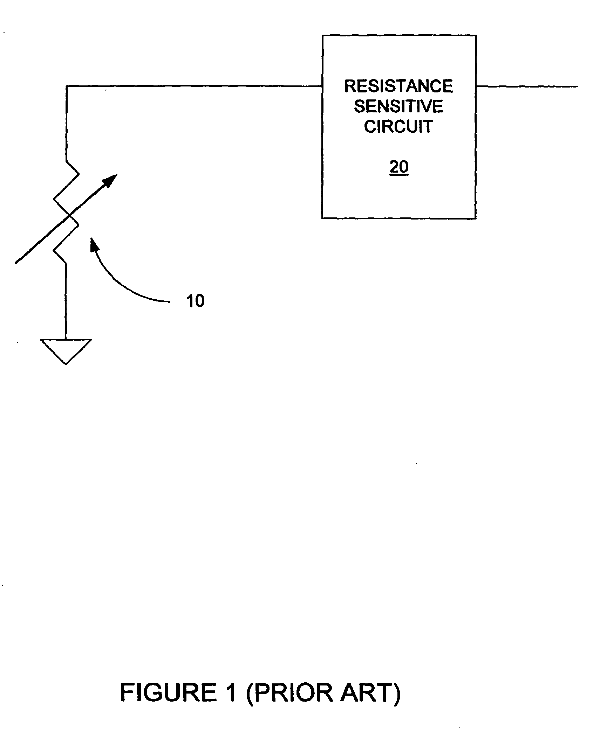

There are many electronics applications that require the use a variable resistance. Many of these applications require a useful range of resistance that varies over several orders of magnitude. Figure 1 shows an adjustable resistor 10 that is used for setting circuit parameters of a resistance sensitive circuit 20. The resistance of the adjustable resistor 10 can, for example, be used for setting a gain of an amplifier or an oscillation frequency of an oscillator.

A method of generating a variable resistance is through the use of strip resistance. Strip resistance requires trimming physically) a resistive material until a desired resistance has been obtained. This requires an iterative approach in which the resistive material is trimmed while monitoring the resulting resistance. A limitation of this approach is that material is physically removed. Therefore, once a resistance has been obtained or selected, it is very difficult to adjust the resistance at a later time.

Another approach includes the use and implementation of active circuits that essentially emulate a resistance. The active circuits can be adjustable to allow additional adjustments of the emulated resistance. A limitation of this approach is that the active circuits can be complex. More specifically, that active device circuits can be difficult to design, and can require additional fabrication processing steps. Additionally, the active devices can require large amounts of circuit substrate area which reduces overall circuit density.

The present invention seeks to provide an improved adjustable resistor.

According to an aspect of the present invention, there is provided an integrated adjustable resistor as specified in claim 1.

The preferred embodiments described herein provide apparatus and a method for providing an adjustable resistance. The resistance may be adjustable over several orders of magnitude of resistance. Additionally, the adjustable resistance can be easy to fabricate, and require minimal circuit substrate surface area.

The invention also provides for apparatus and a method for providing an adjustable resistance. The resistance is adjustable over several orders of magnitude of resistance. Additionally, the adjustable resistance is easy to fabricate, and requires minimal circuit substrate surface area.

A first embodiment of the invention includes an integrated adjustable resistor. The integrated adjustable resistor includes a first electrode, a second electrode, and a phase change medium electrically connected to the first electrode and the second electrode. The integrated adjustable resistor preferably includes an adjustable pulse generator for applying a variable amount of energy to the phase change medium. A resistance of the phase change medium is continuously dependent upon the amount of energy applied to the phase change medium. A resistance dependent circuit is electrically connected to the first electrode and the second electrode. Operation of the resistance dependent circuit is continuously dependent upon the resistance of the phase change medium.

Embodiments of the present invention are described below, by way of example only, with reference to the accompanying drawings, in which:

Figure 1 shows a prior art variable resistance and a resistance sensitive circuit;

Figure 2 shows an embodiment of an integrated adjustable resistor according to an embodiment of the invention;

Figure 3 shows a relationship between resistance of a phase change medium material versus an amplitude of an applied pulsed voltage potential;

Figures 4A and 4B show waveforms of a voltage and temperature that is applied to a phase change medium to programmably set the resistance of the phase change medium;

Figure 5 shows another embodiment of an integrated adjustable resistor according to an embodiment of the invention;

Figure 6 shows another embodiment of an integrated adjustable resistor according to an embodiment of the invention;

Figure 7 is a plot showing the resistance of a phase change material after many cycles of applied pulsed voltage potentials;

Figure 8 shows an integrated adjustable resistor and resistance dependent low pass filter circuit according to an embodiment of the invention;

Figure 9 shows an integrated adjustable resistor and resistance dependent band pass filter circuit according to an embodiment of the invention;

Figure 10 shows an integrated adjustable resistor and resistance dependent amplifier circuit according to an embodiment of the invention;

Figure 11 shows an integrated adjustable resistor and resistance dependent summing circuit according to an embodiment of the invention; and

Figure 12 shows a neural network that uses several integrated adjustable resistor and resistance dependent summing circuits according to an embodiment of the invention.

The embodiments described provides apparatus and a method for providing an adjustable resistance. The resistance is adjustable over several orders of magnitude of resistance. Additionally, the adjustable resistance is easy to fabricate, and requires minimal circuit substrate surface area.

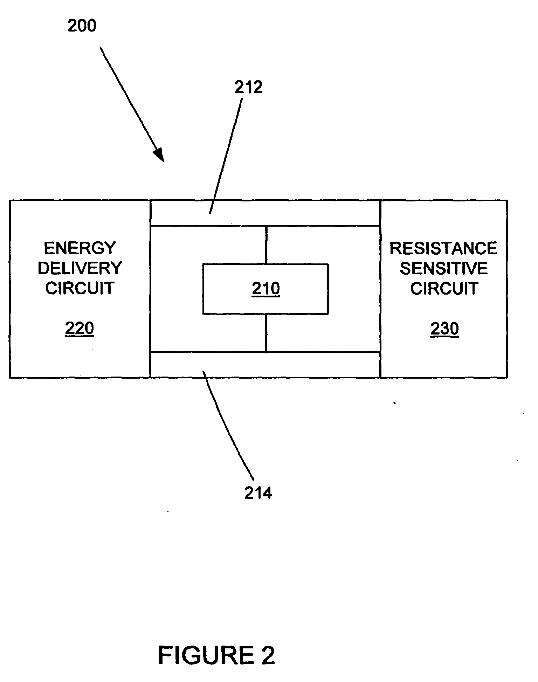

Figure 2 shows an embodiment of an integrated adjustable resistor 200 according to an embodiment of the invention. The integrated adjustable resistor 200 includes a first electrode 212 and a second electrode 214. A phase change media 210 can be electrically connected to the first electrode 212 and the second electrode 214. An adjustable pulse generator (energy delivery circuit) 220 can be used for applying a variable amount of energy to the phase change media 210. A resistance of the phase change media 210 is continuously dependent upon the amount of energy applied to the phase change media 210. The embodiment further includes a resistance dependent circuit 230. The resistance dependent circuit 230 is electrically connected to the first electrode 212 and the second electrode 214. Operation of the resistance dependent circuit 230 is continuously dependent upon the resistance of the phase change media 210.

The phase change medium 210 generally includes a resistance that is set to a particular one of a continuous range of physical states of the phase change material. For example, a first physical state of the phase change medium 210 can include a high electrical resistance state, and a second physical state of the phase change medium 210 can include a low electrical resistance state. Depending upon an amount of energy delivered to the phase change medium 210, any value of resistance between the high electrical resistance and the low resistance can obtained.

A particular phase change medium 210 can include the first physical state being an amorphous state that includes a high electrical resistance. The phase change medium 210 can further include the second physical state being a crystalline state that includes a low electrical resistance. Depending upon an amount of energy delivered to the phase change medium 210, the portion of the phase change medium 210 that is amorphous, and the portion of the phase change medium 210 that is crystalline can be adjusted, and therefore, the resistive state of the phase change medium can be adjusted.

The energy delivery circuit 220 generally includes a voltage pulse generator that applies a variable amount of energy to the phase change medium 210. The energy delivery circuit 220 can be electrically connected to the first electrode 212 and the second electrode 214. As will be described, the amount of energy delivered to the phase change medium 210 generally determines the resistive state of the phase change medium 210. Generally, the energy delivery circuit 220 can generate a pulsed voltage that includes a voltage potential that can be continuously adjusted over a wide enough range that the resistance of the phase change medium 210 can be properly adjusted. Voltage pulse generators that can provide a continuously adjustable voltage amplitude are well known in the art of electronics.

The resistance sensitive circuit 230 can be electrically connected to the first electrode 212 and the second electrode 214. Generally, the resistance of the phase change medium 210 determines operation of the resistance sensitive circuit 230.

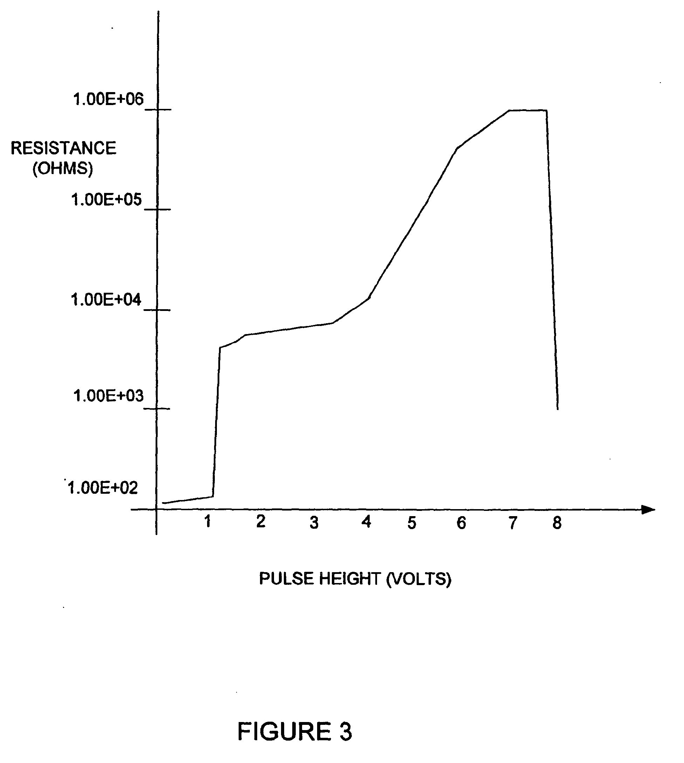

Figure 3 shows a relationship between resistance of a phase change medium versus an amplitude of an applied pulsed voltage potential. The previously described energy delivery circuit can be used to deliver the pulsed voltage potential. The material characteristics of this particular phase change medium includes $In_2Se_3$.

As the plot of Figure 3 shows, the resistance of the phase change medium can be continuously adjusted over a wide range of resistance. As the plot shows, the usable resistance can be adjusted over several orders of magnitude of resistance.

The application of a great enough voltage causes Joule heating of the phase change medium which transform a portion of the phase change medium to an amorphous state. The greater the voltage potential, the greater the Joule heating and, therefore, the greater the amount of phase change medium that is changed to an amorphous state. A feature of these embodiments is application of a continuously variable voltage potential, and therefore, the generation of a continuously variable phase change medium resistance.

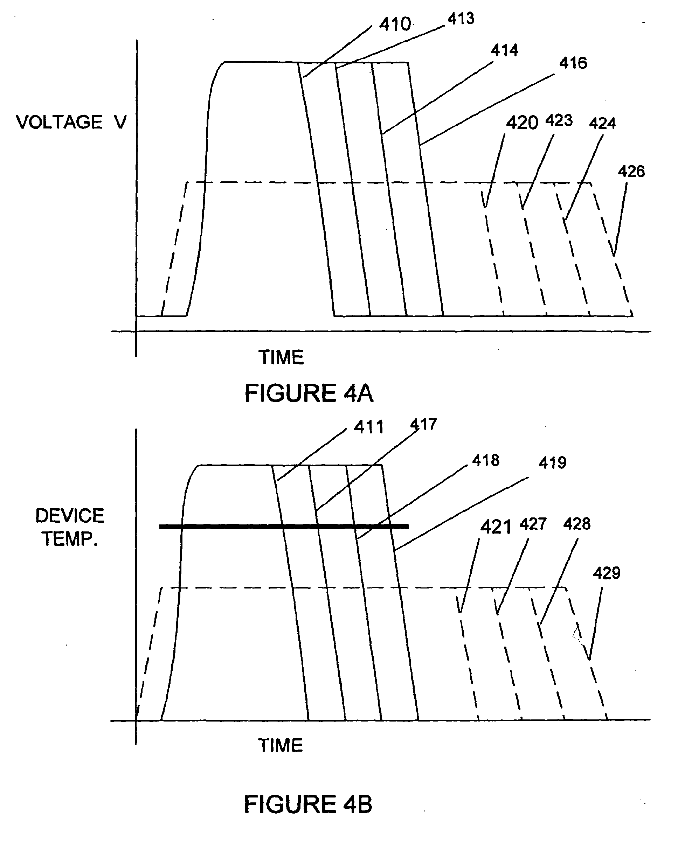

Figures 4A and 4B show waveforms of a voltage and temperature that is applied to a phase change medium to programmably set the resistance of the phase change medium.

Figure 4A shows a voltage potential that can be adjustably applied to a phase change medium to adjustably set the resistance of the phase change medium. A first set of voltage potentials 410, 413, 414, 416 programmably adjust the amount of the phase change medium that is amorphous. A second set of voltage potentials 420, 423,, 424, 426 programmably adjust the amount of the phase change medium that is converted back to crystalline after being at least partially converted to being amorphous.

The second set of voltage potentials 420, 423, 424, 426 includes a lower voltage that is applied for a longer duration. These signals can transform variable amounts of the phase change material back to a crystalline state.

Figure 4B shows typical device temperature traces 411, 417, 418, 419 and 421, 427, 428, 429 that correspond with the voltage waveforms 410, 413, 414, 416 and 420, 423, 424, 426, 220 of Figure 4A. The first voltage waveforms 410, 413, 414, 416 generate first temperature traces 411, 417,418, 419 that exceed a melting temperature (designated by line 225) of the phase change medium. Generally, the applied voltages convert a variable amount of the phase change material to an amorphous state.

The second voltage waveforms 420, 423, 424, 426 generate second temperature traces 421, 427, 428, 429 that do not exceed the melting temperature of the phase change medium. However, the second temperature traces 421, 427, 428, 429 show that the temperature of the phase change material is elevated for a longer period of time. Generally, the applied voltages convert a variable amount of the phase change material to a crystalline state.

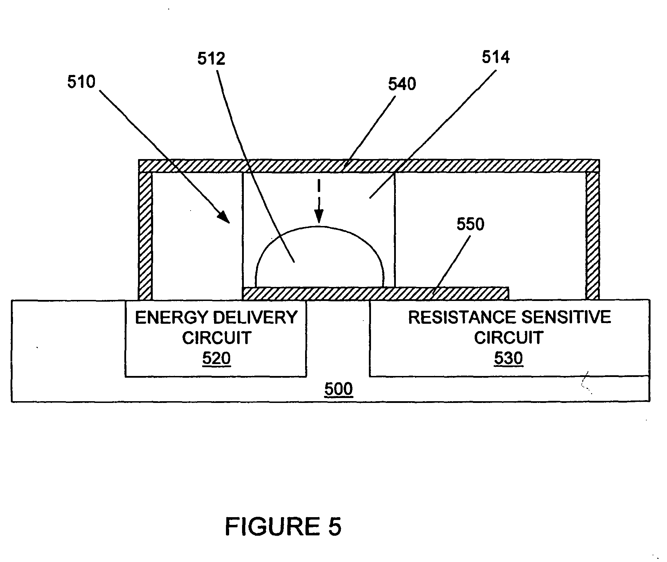

Figure 5 shows another embodiment of an integrated adjustable resistor according to an embodiment of the invention. This embodiment shows that the adjustable resistor can be easily integrated with electronic circuits of both the resistance sensitive circuit 530, and the energy delivery circuit 520. Figure 5 shows a phase change medium 510 in greater detail. A first conductive electrode 540 and a second conductive electrode 550 are electrically connected to a phase change material medium 510.

A voltage potential applied between the first conductive electrode 540 and a second conductive electrode 550 causes current (I) to flow through the first conductive electrode 540, the phase change medium 510 and the second conductive layer 550. The conducted current causes heat to be generated in the phase change material layer 540, that can cause the phase change material layer 510 to change physical states. A first physical state can include a low resistance state (typically crystalline) and a second physical state can include a high resistance state (typically amorphous). By controlling the voltage and current applied to the first conductive electrode 540 and a second conductive electrode 550, the physical state (high or low resistance) can be controlled. Generally, the phase change medium will include a portion of the phase change medium 510 that is partially altered between one of the two physical states.

As previously mentioned, the physical state of the phase change medium can be used by the resistance sensitive circuit 550. Clearly, the resistance sensitive circuit 550 cannot include applying a voltage or current while utilising the resistance of the phase change medium 510 that can change or modify the physical state of the phase change medium 510. That is, operations of the resistance sensitive circuit 530 should not modify or alter the present physical state of the phase change medium 510.

The current (I) conducted through the phase change medium 510 causes heat to be generated within the phase change medium 510. The amount of heating generally determines how much of the phase change medium 510 is converted to an amorphous state 512 and how much of the phase change medium is in a crystalline state 514. The amount of the phase change medium 510 that is amorphous 512 and the amount of the phase change medium 510 is crystalline 514, determine the resistance of the phase change medium 510.

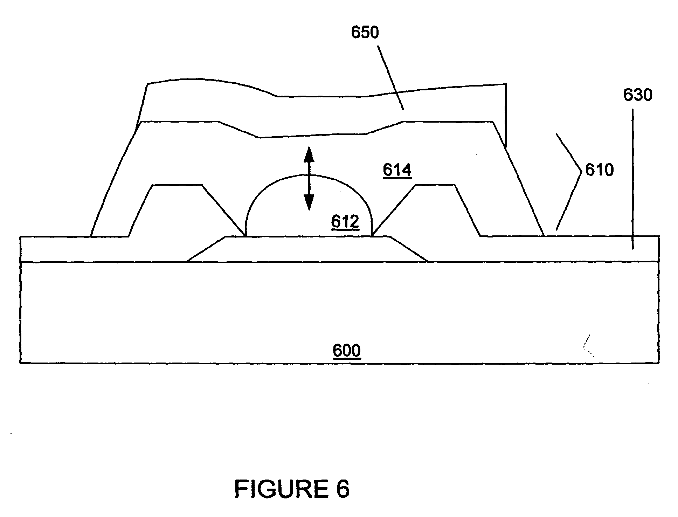

Figure 6 shows another embodiment of an integrated adjustable resistor according to an embodiment of the invention. This embodiment shows the phase change medium in greater detail. This embodiment includes a substrate 600, a first conductive electrode 640, a phase change medium 610 and a second conductive electrode 650.

The substrate 600 can be formed from Silicon, a Silicon Oxide, an Aluminium Oxide, a Magnesium Oxide, or other types of well-known ceramics. However, this list in not an exhaustive list. Other materials can be used to form the substrate 400.

The first conductive electrode 640 can be formed from Copper, Aluminium, Tungsten or alloys thereof. However, this list in not an exhaustive list. Other materials can be used to form the first conductive electrode 640.

The insulator layer 630 can be formed from Silicon oxides, Boron Phosphorous Silicate Glass, Boron Silicate Glass or Phosphorous Silicate Glass. However, this list in not an exhaustive list. Other materials can be used to form the insulator layer 434.

The phase change medium 610 can be formed from a group of elements selected from Te, Se, Ge, Sb, Bi, Pb, Sn, As , S. The formation of phase change materials is well-know in the field of material science. As previously described, the phase change medium 610 generally includes an amorphous portion 612, and a crystalline portion 614.

A semiconductor-based phase change medium for in high density electronic devices should have a reasonable low melting temperature and a readily achievable change in solid state phase between crystalline states and amorphous states, or between differentiable crystalline states. The phase change medium should be chemically stable over a great number of phase changes.

Various embodiments of the invention include polycrystalline indium and gallium chalcogenides as suitable semiconductor media for incorporation into high density phase change media. The materials have reasonable low melting temperatures and are easily converted between crystalline and amorphous states, and have convenient and controllable carrier density and band gaps. Additionally, these materials have low defect densities, and have high stability. Polycrystalline indium and gallium chalcogenides are easily fabricated into semiconductor films using standard fabrication techniques. An additional advantage of indium and gal hum chalcogenides is that their band gaps are slightly larger than the band gap of silicon.

Several compounds have been found to include desirable semiconductor properties for use as phase change medium resistors. For example, InSe, $In_2Se_3$, InTe, $In_2Te_3$ and InSeTe. Solid solutions of these indium based semiconductor compounds also include desirable properties.

Gallium solutions include GaSe, $Ga_2Se_3$, GaTe, $Ga_2Te_3$, GaSeTe. Solid solutions of these gallium base semiconductors compounds also have desirable semiconductor properties for use in phase change medium resistors.

Indium gallium chalcogenides such as $InGaSe_2$ and $InGaTe_2$, and quaternary compounds containing indium, gallium, selenium and tellurium, such as InGaSeTe are also found to have desirable semiconductor properties for use in phase change medium resistors.

The above-identified indium, gallium, and indium-gallium chalcogenides may be doped with group I, Ii, V or VI elements.

The second conductive electrode 650 can be formed from Copper, Aluminium, Tungsten or alloys thereof. However, this list in not an exhaustive list. Other materials can be used to form the second substantially planar conductive electrode 650.

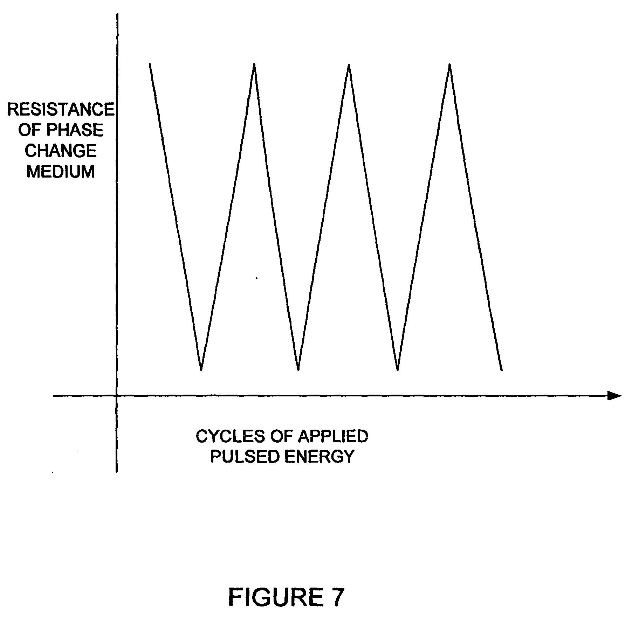

Figure 7 is a plot showing the resistance of a phase change material after many cycles of applied pulsed voltage potentials. This plot shows that the resistance of the phase change medium can be adjusted many times. Generally, there is no limitation on the number of times the phase change medium can be resistively adjusted.

The characteristic of the phase change material that allows the resistance of the phase change material to be adjusted repeatedly is very desirable. A resistance within a resistance dependent circuit can be adjusted over and over. Therefore, the resistance dependent circuit is adaptable to adjustment over time. Many electronic circuits can utilise this useful feature.

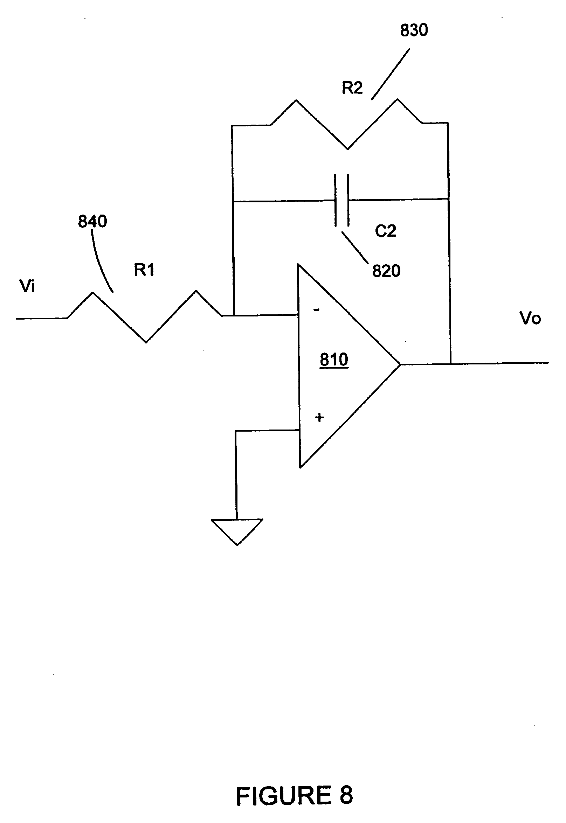

Figure 8 shows an integrated adjustable resistor and resistance dependent low pass filter circuit 800 according to an embodiment of the invention. The low pass filter circuit includes an amplifier 810, a feedback capacitor (C2) 820, a feedback resistor (R2) 830 and an input resistor (R1) 840.

The output Vo to input Vi relationship of the low pass filter circuit can be represented by:

$$(Vo/Vi) \ ((R2/R1)/(1-R2C2s)).$$

Tuning of the feedback resistor r2 provides tuning of the cut-off frequency of the low pass filter. Providing a wide tuning range of the resistance of the feedback resistor R2 provides a wide tuning range of the cut-off frequency of the low pass filter.

The feedback resistor R2 can be implemented as a phase change medium variable resistor of the type taught herein. The phase change medium variable resistors provide a wide range of tunable resistance. The physical implementation of the phase change medium resistors are small and are easily integrated with the electronic circuit associated with the low pass filter.

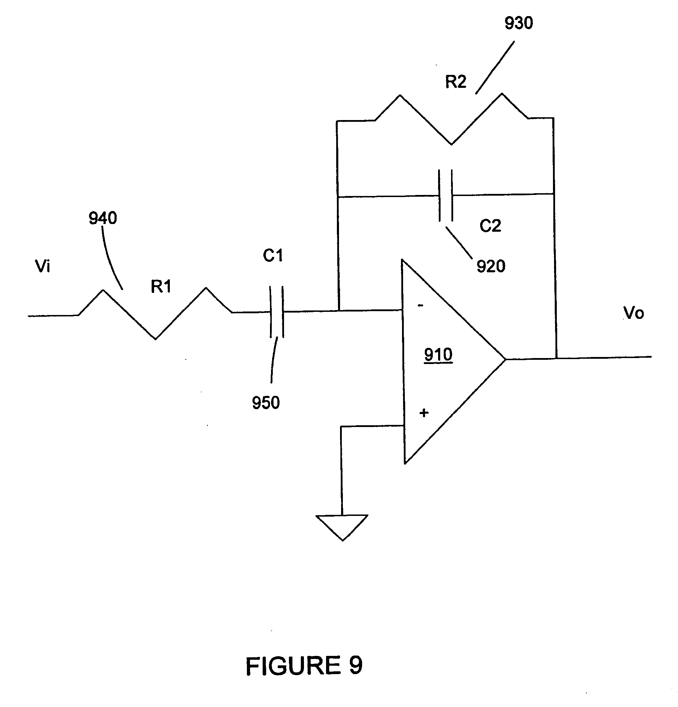

Figure 9 shows an integrated adjustable resistor and resistance dependent band pass filter circuit 900 according to an embodiment of the invention. The band pass filter circuit 900 includes an amplifier 910, a feedback capacitor (C2) 920, a feedback resistor (R2) 930, an input resistor (R1) 940, and an input capacitor (C1) 950.

The output Vo to input Vi relationship of the band pass filter circuit can be represented by:

$$(Vo/Vi) \ ((R2C1s)/(1-R2C2s)(1+R1C1s)).$$

Tuning of the feedback resistor R2 provides tuning of the high end cut-off frequency of the band pass filter. Providing a wide tuning range of the resistance of the feedback resistor R2 provides a wide tuning range of the high end cut-off frequency of the low pass filter.

For example, if a selection is made of R1 = 100Ω, C1 = 3.18 μF, R2 = 10 KΩ, and C2 = 318 pF, then the low end cut off frequency of the band pass filter is 1 kHz and the high end cut off frequency is 100 kHz. If the feed back resistor R2 is implemented with a phase change medium, and the resistance of the feed back resistor R2 is adjusted from 10 KΩ to 100 KΩ, then the high end cut off frequency of the band pass filter is adjusted to 10 kHz.

The phase change medium variable resistors disclosed herein provide a wide range of tunable resistance. The physical implementation of the phase change medium resistors are small and are easily integrated with the electronic circuit associated with the band pass filter. The adjustable resistance of the phase change medium can be programmed precisely and quickly while the associated circuitry is operating. Therefore, the characteristics of the band pass filter circuitry can be modified dynamically.

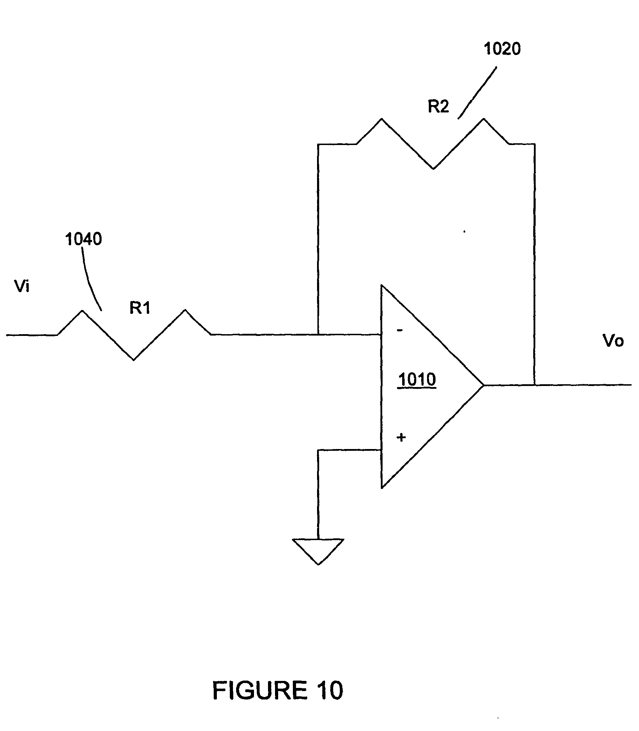

Figure 10 shows an integrated adjustable resistor and resistance dependent amplifier circuit 1000 according to an embodiment of the invention. The amplifier includes a gain element 1010, a feed back resistor (R2) 1020 and an input resistor (R1) 1030.

The output Vo to input Vi relationship of the variable gain circuit 1000 can be represented by:

$$(Vo/Vi) = -(R2/R1).$$

The resistance of the phase change medium can be used to implement the feed back resistors 1020. Therefore, the gain of the variable gain circuit 1000 can be dynamically adjusted.

As previously stated, the phase change medium variable resistors taught herein provide a wide range of tunable resistances. The physical implementations of the phase change medium resistors are small and are easily integrated with the electronic circuit associated with the variable gain circuit 1000. The adjustable resistance of the phase change medium can be programmed precisely and quickly while the associated circuitry is operating. Therefore, the characteristics of the variable gain circuit can be modified dynamically.

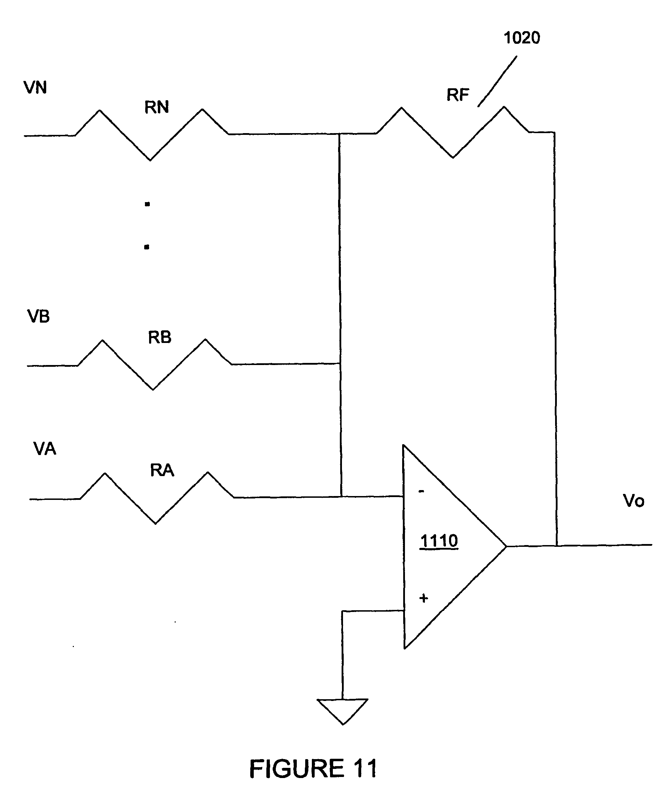

Figure 11 shows an integrated adjustable resistor and resistance dependent summing circuit 1110 according to an embodiment of the invention. The summing circuit 1100 includes an amplifier 1110, a feed back resistor (RF) 1120, and multiple input resistors RA, RB .... RN. The summing circuit 1100 receives multiple input signals VA, VB .... VN. The contribution of each of the input signals VA, VB .... VN to an output Vo can be given as:

Vo (RF/RA) * VA + (RF/ RB) * VB + ..., (RF/RN) * VN.

The feed back resistor (RF) 1120 can be implemented with a phase change medium adjustable resistor of the type taught herein. Alternatively, the input resistors RA, RB .... RN can each be implemented with the adjustable resistor of the type taught herein. Therefore, the contribution to the output Vo of each of the input signals VA, VB .... VN can be programmably adjusted. The adjustable resistance of the phase change medium can be programmed precisely and quickly while the associated circuitry is operating. Therefore, the characteristics of the summer circuitry can be modified dynamically.

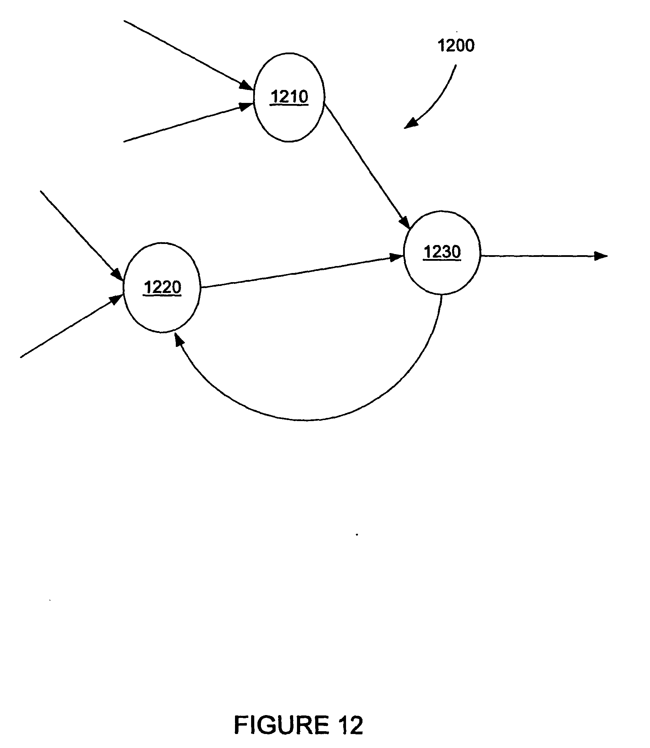

Figure 12 shows a neural network 1200 that uses several integrated adjustable resistor and resistance dependent summing circuits according to an embodiment of the invention. The summing circuit 1110 of Figure 11 can be extended to provide an electronic implementation of a neural network. Neural networks are generally large networks that include many summing nodes.

The neural network 1200 of Figure 12 includes many nodes. Three exemplary nodes 1210,1220, 1230 are shown. The nodes receive inputs and generate at least one output. The outputs of each of the nodes can be connected to other nodes.

Generally, each of the nodes operates as a summer as provided in Figure 11. The summers can include a feature that an output (can be a pulse) is generated only when the sum of the inputs exceed a threshold value. The summers of the nodes generate an output pulse only when the sum of the inputs to the nodes exceed a predetermined threshold value.

A neural network will generally include many of the nodes as shown in Figure 12. Each of the nodes receive many inputs, and generally feedback upon themselves.

By using the teachings herein, a very small programmable resistance can be incorporated into a cross-point junction of two electrodes. An embodiment can include a large cross-point array in which the conductors are laid out in two or more planes (similar to an MRAM array) with the programmable resistance being placed at select few cross-points in the array. The conductors can form a set of connections such that the whole array functions as a neural network. An architecture including the taught resistors can be used to realise a highly integrated and densely packed design of a neural network. Again, this architecture is possible due to the very small physical size of the programmable resistors.

The disclosures in United States patent application no. 10/462,155, from which this application claims priority, and in the abstract accompanying this application are incorporated herein by reference.

**Claims**

1. An integrated adjustable resistor (200) including:

   a first electrode (212);
   a second electrode (214);
   a phase change medium (210) electrically connected to the first electrode (212) and the second electrode (214);
   an adjustable pulse generator (220) for applying a variable amount of energy to the phase change medium (210), a resistance of the phase change medium (210) being continuously dependent upon the amount of energy applied to the phase change medium (210); and
   a resistance dependent circuit (230), the resistance dependent circuit (230) electrically connected to the first electrode (212) and the second electrode (214), operation of the resistance dependent circuit (230) being continuously dependent upon the resistance of the phase change medium (210).

2. A resistor as in claim 1, wherein the resistance of the phase change medium (210) is adjustable over orders of magnitude.

3. A resistor as in claim 1 or 2, wherein the adjustable pulse generator (220) can provide energy to the phase change medium (210) that is adjustable over orders of magnitude.

4. A resistor as in claim 1, 2 or 3, wherein the adjustable pulse generator (220) can programmably provide energy to the phase change medium (210).

5. A resistor as in any preceding claim, wherein the adjustable pulse generator (220) can dynamically provide energy to the phase change medium over time (210).

**6.** A resistor as in any preceding claim, wherein the adjustable pulse generator (220) is calibrated to provide particular amounts of energy that correspond to particular values of resulting resistance of the phase change medium (210).

**7.** A resistor as in any preceding claim, wherein the phase change medium (210) and the resistance dependent circuit (230) are physically located on a common substrate.

**8.** A resistor as in claim 7, wherein the phase change medium (210) is located proximate to a via within the substrate, and is approximately a same size as the via.

**9.** A resistor as in any preceding claim, wherein the phase change medium (210) is integrated with a transistor of the resistance dependent circuit (230).

**10.** A resistor as in any preceding claim, wherein the resistance of the phase change medium (210) is non-volatile.

RESISTANCE
SENSITIVE
CIRCUIT

<u>20</u>

10

FIGURE 1 (PRIOR ART)

200

212

| ENERGY DELIVERY CIRCUIT 220 | 210 | RESISTANCE SENSITIVE CIRCUIT 230 |

214

# FIGURE 2

FIGURE 3

FIGURE 4A

FIGURE 4B

FIGURE 5

**FIGURE 6**

RESISTANCE
OF PHASE
CHANGE
MEDIUM

CYCLES OF APPLIED
PULSED ENERGY

FIGURE 7

**FIGURE 8**

FIGURE 9

FIGURE 10

FIGURE 11

**FIGURE 12**